# EUROPEAN PATENT SPECIFICATION

(11) **EP 1 032 971 B1**
(45) Date of publication and mention of the grant of the patent: **04.12.2002**
(21) Application number: 99928007.6
(22) Date of filing: 18.06.1999
(51) Int. Cl.: H03B 5/12

(54) **VOLTAGE CONTROLLED OSCILLATOR CIRCUIT**
SPANNUNGSGESTEUERTE OSZILLATORSCHALTUNG
CIRCUIT A OSCILLATEUR COMMANDE EN TENSION

(30) Priority: 24.06.1998 GB 9813585
(43) Date of publication of application: 06.09.2000
(73) Proprietor: MOTOROLA, INC., Schaumburg, IL 60196 (US)
(72) Inventor: FRUND, Jean, Daniel, F-74160 Saint Julien en Genevois (FR)
(74) Representative: Hudson, Peter David
(86) International application number: EP9904272
(87) International publication number: WO99067876

(56) References cited:
- WO-A-83/03533
- US-A- 4 847 876
- US-A- 5 245 298
- PATENT ABSTRACTS OF JAPAN vol. 009, no. 298 (E-361), 26 November 1985 (1985-11-26) & JP 60 136402 A (SONY KK), 19 July 1985 (1985-07-19)
- PATENT ABSTRACTS OF JAPAN vol. 015, no. 209 (E-1072), 28 May 1991 (1991-05-28) & JP 03 058505 A (NEC CORP;OTHERS: 01), 13 March 1991 (1991-03-13)

## Description

### Field of the Invention

This invention relates to Voltage Controlled Oscillator (VCO) circuits and particularly but not exclusively to VCO's with resonator circuits.

### Background of the Invention

VCO's with L-C resonator (or tank) circuits are used in many mixer-oscillator applications such as terrestrial and satellite television receivers, wireless communications and the like.

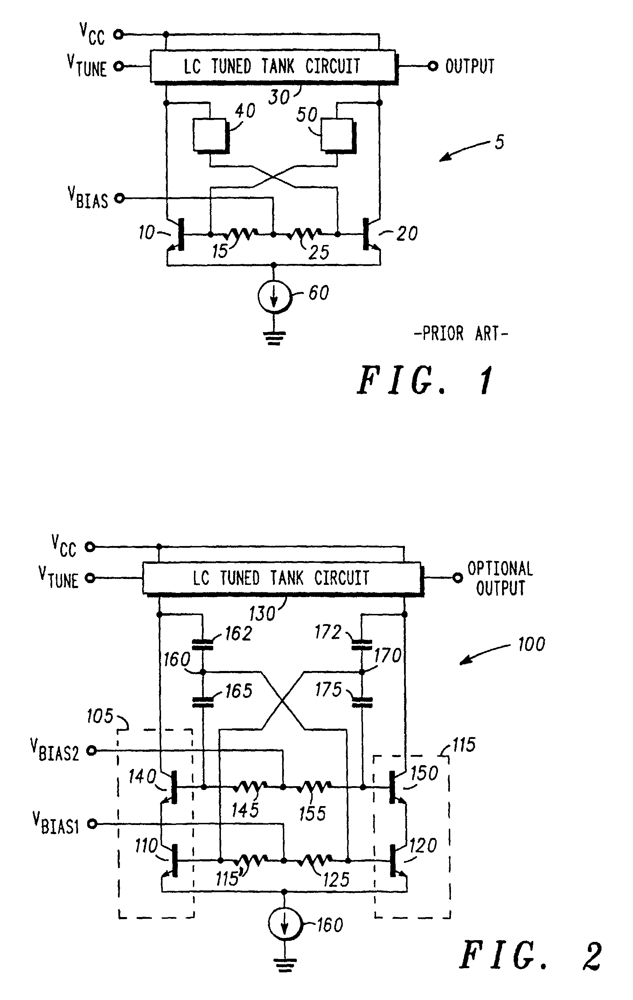

An example of such a VCO is shown in FIG. 1, which depicts a prior art emitter-coupled oscillator 5, having first and second emitter-coupled transistors 10 and 20 respectively coupled via their collector terminals to two terminals of a tank circuit 30. First and second feedback paths 40 and 50 respectively are cross-coupled between the two terminals of the tank circuit 30 and base terminals of the first and second transistors 10 and 20 respectively. The emitter terminals of the first and second transistors 10 and 20 respectively are coupled to a current source 60. A bias voltage is applied to the base terminals of the first and second transistors 10 and 20 via first and second biasing resistors 15 and 25 respectively.

Such a VCO is described in U.S. Patent 4,847,876.

The circuit of FIG. 1 allows a reasonably high amplitude of oscillation, but suffers from a low effective quality factor (as load effects increase the effective resistance of the circuit), and from phase perturbation, caused by base currents associated with the capacitive couplings. Furthermore, the first and second emitter-follower transistors 10 and 20 give rise to the unwanted effects of a large noise factor and open loop phase error.

Other circuits such as a cascode arrangement are known, which provide advantages over the circuit of FIG. 1 in terms of the quality factor. However, such circuits again suffer from open loop phase error, noise contribution due to the additional transistors in the feedback paths (increasing the phase noise) and increased power consumption.

This invention seeks to provide a VCO circuit which mitigates the above mentioned disadvantages.

### Summary of the Invention

According to the present invention there is provided a VCO circuit, comprising: a resonant tank circuit; a differential pair of transistors, coupled to drive the tank circuit; a differential cascode pair, coupled between the differential pair and the tank circuit, the cascode pair having base terminals and, a differential feedback path, cross-coupled from the tank circuit to drive the differential pair, wherein the base terminals of the cascode pair are AC cross-coupled with respect to the differential pair such that AC base currents of the differential pair and the cascode pair are cross-compensated.

Preferably the differential feedback path includes first DC blocking capacitors. The base terminals of the differential cascode are preferably AC cross-coupled to the differential pair by means of second DC blocking capacitors, such that the cascodes act as diodes for the AC signal.

Preferably the VCO circuit further comprises biasing resistors coupled to bias the base terminals of the cascode pair, and preferably also further comprises an output amplifier comprising a supplementary differential pair and a supplementary cascode, each coupled to the differential pair and the cascode respectively, for providing a differential amplified output.

The supplementary differential pair and the supplementary cascode are preferably coupled to the differential pair and the cascode via their base terminals respectively. Preferably the differential amplified output is provided at collector terminals of the supplementary cascode.

In this way a low phase noise and low power VCO circuit is provided by having a good effective quality factor (increased input and output impedances of the amplifier), low noise figure of the amplifier (no additional transistor in the feedback paths), reduced open loop phase error (negligible time delay in the feedback paths) and high amplitude of oscillation.

### Brief Description of the Drawings

An exemplary embodiment of the invention will now be described with reference to the drawing in which:
FIG. 1 shows a prior art VCO circuit; and
FIG. 2 shows a preferred embodiment of a VCO circuit in accordance with the invention.

### Detailed Description of a Preferred Embodiment

Referring to FIG. 2, there is shown a VCO circuit 100, having first and second cascode two-transistor subcircuit of transistors 105 and 115 respectively, coupled to a terminals of a tank circuit 130.

The first cascode two-transistor subcircuit 105 has a first transistor 110, which has an emitter terminal coupled to a current source 160, a base terminal coupled to a first voltage bias VBIAS1 via a first biasing resistor 115', and a collector terminal to be further described below. The first cascode pair 105 also has a second transistor 140, which has an emitter terminal coupled to the collector terminal of the first transistor 110, a base terminal coupled to a second voltage bias VBIAS2 via a second biasing resistor 145, and a collector terminal coupled to a first terminal of the tank circuit 130.

The second cascode two-transistor subcircuit 115 has a third transistor 120, which has an emitter terminal coupled to the current source 160, a base terminal coupled to the first voltage bias VBIAS1 via a third biasing resistor 125, and a collector terminal to be further described below. The second cascode pair 115 also has a fourth transistor 150, which has an emitter terminal coupled to the collector terminal of the third transistor 120, a base terminal coupled to the second voltage bias VBIAS2 via a fourth biasing resistor 155, and a collector terminal coupled to a second terminal of the tank circuit 130.

In this way the first and third transistors 110 and 120 respectively, form a differential pair which drive the tank circuit 130, and the second and fourth transistors 140 and 150 form a differential cascode pair, which act as cascodes with respect to the differential pair (transistors 110 and 120).

A first feedback path is formed between the first terminal of the tank circuit 130 and the base terminal of the third transistor 120 via a first node 160. A first DC blocking capacitor 162 is coupled between the first terminal of the tank circuit and the first node 160. The first node 160 is also coupled to the base terminal of the second transistor 140 via a second DC blocking capacitor 165.

A second feedback path is formed between the second terminal of the tank circuit 130 and the base terminal of the first transistor 110 via a second node 170. A third DC blocking capacitor 172 is coupled between the second terminal of the tank circuit and the second node 170. The second node 170 is also coupled to the base terminal of the fourth transistor 150 via a fourth DC blocking capacitor 175.

In this way the first and second feedback paths form a cross-coupled differential feedback path to the differential pair (transistors 110 and 120), and the cascode pair (transistors 140 and 150) are AC cross-coupled with respect to the differential pair (transistors 110 and 120).

In operation, the oscillation frequency is set by inductive and capacitive values of the tuned tank circuit. Voltage variable capacitors (VVCs) or varactors provide tuning of the tank circuit 30. The ratio of the maximum to minimum total capacitance associated with the VVC and all the parasitic capacitances connected to the tank circuit set the tuning frequency range of the VCO 100.

The centre frequency of the VCO 100 is controlled by a DC voltage connected to VTUNE which modulate the total capacitance value of the tank circuit 30.

The differential pair made by transistors 110, 120, the current source 160 and the tank circuit 30 provide the necessary gain and limiting conditions for stale oscillation of the VCO 100.

It is noted that an AC coupling achieved by way of a capacitor and separate current sources may be preferred to the DC coupling in the differential pair between the emitters of transistors 110 and 120 to provide rejection of low frequency spurious signals and low frequency noise from the current sources and ensure oscillation in the frequency range of the VCO 100. In addition, the oscillation amplitude may be set by an automatic gain control circuit (AGC) to remove AM components and low frequency modulation of the bias voltage controlling the current sources.

The AC base and collector voltages of the second transistor 140 and fourth transistor 150 are approximately equal. These transistors 140 and 150 act as diodes at the oscillation frequency and cascodes for low frequencies. Since the noise contribution of the cascodes can be neglected, these transistors can be relatively small compared to the first transistor 110 and third transistor 120. This serves to reduce the parasitic capacitances on the tank circuit 130 and improve the tuning frequency range.

The capacitive couplings associated with the first and second feedback paths allow high amplitude oscillation on the tank circuit 130. Furthermore, the AC base currents of the differential pair made by transistors 110 and 120 flowing through the third and first capacitors 172 and 162 are compensated at nodes 170 and 160 respectively by the AC base currents of transistor 150 and transistor 140 flowing through capacitor 175 and capacitor 165 respectively. Therefore, the AC base currents in the positive feedback paths made by capacitors 162 and 172 are reduced, giving rise to a low circuit noise factor.

In this way the cross-coupled arrangement, the differential pair, the cascode pair and the feedback paths reduce the phase noise by reducing the noise contribution of the base currents of the differential pair in the feedback paths.

It will be appreciated that alternative embodiments to the one described above are possible. For example, an output amplifier comprising a supplementary differential pair and a supplementary cascode could be coupled to the differential pair and the cascode respectively, for providing a differential amplified output. In such an arrangement the supplementary differential pair and the supplementary cascode would be coupled to the differential pair and the cascode via their base terminals respectively, and the differential amplified output would be provided at collector terminals of the supplementary cascode.

In this way the tank circuit 130 would not need to be provided with an output to derive the oscillations, but these may instead be sensed from the output amplifier.

## Claims

1. A VCO circuit, comprising:
a resonant tank circuit (130);
a differential pair of transistors (110,120) coupled to drive the tank circuit (130),
a differential cascode pair (140,150), coupled between the differential pair (110,120) and the tank circuit, the cascode pair (140,150) having base terminals and,
a differential feedback path, cross-coupled from the tank circuit (130) to drive the differential pair (110,120),
wherein the base terminals of the cascode pair (140,150) are AC cross-coupled with respect to the differential pair (110,120) such that AC base currents of the differential pair and the cascode pair are cross-compensated.

2. The VCO circuit as set forth in claim 1 wherein the differential feedback path includes first DC blocking capacitors (162,172).

3. The VCO circuit as set forth in claim 1 or claim 2 wherein the base terminals of the differential cascode pair (140,150) are AC cross-coupled to the differential pair by means of second DC blocking capacitors (165,175), such that the cascodes act as diodes for the AC signal.

4. The VCO circuit as set forth in any preceding claim further comprising biasing resistors (145,155) coupled to bias the base terminals of the cascode pair (140,150).

5. The VCO circuit as set forth in any preceding claim further comprising an output amplifier comprising a supplementary differential pair and a supplementary cascode pair, each coupled to the differential pair and the cascode pair respectively, for providing a differential amplified output.

6. The VCO circuit as set forth in claim 5, wherein the supplementary differential pair and the supplementary cascode pair are coupled to the differential pair and the cascode pair via their base terminals respectively.

7. The VCO circuit as set forth in claim 5, wherein the differential amplified output is provided at collector terminals of the supplementary cascode pair.

## Patentansprüche

1. Spannungsgesteuerte Oszillatorschaltung (VCO-Schaltung), die Folgendes umfasst:
einen resonanten Oszillatorschwingkreis (130) ;
zwei differenzielle Transistoren (110, 120), die so geschaltet sind, dass sie den Oszillatorschwingkreis (130) ansteuern,
zwei differenzielle Kaskoden (140, 150), die zwischen den zwei differenziellen Transistoren (110, 120) und den Oszillatorschwingkreis geschaltet sind, wobei die zwei Kaskoden (140, 150) Basisanschlüsse haben, und
eine differenzielle Rückkopplungsstrecke, die von dem Oszillatorschwingkreis (130) her kreuzweise geschaltet ist, um die zwei differenziellen Transistoren (110, 120) anzusteuern,
wobei die Basisanschlüsse der zwei Kaskoden (140, 150) in Bezug auf die zwei differenziellen Transistoren (110, 120) kreuzweise mit Wechselstrom geschaltet sind, so dass Basiswechselströme der zwei differenziellen Transistoren und der zwei Kaskoden kreuzweise kompensiert werden.

2. Spannungsgesteuerte Oszillatorschaltung nach Anspruch 1, bei der die differenzielle Rückkopplungsstrecke erste Gleichstromsperrkondensatoren (162, 172) umfasst.

3. Spannungsgesteuerte Oszillatorschaltung nach Anspruch 1 oder Anspruch 2, bei der die Basisanschlüsse der zwei differenziellen Kaskoden (140, 150) mit Hilfe der zweiten Gleichstromsperrkondensatoren (165, 175) mit Wechselstrom kreuzweise mit den zwei differenziellen Transistoren gekoppelt sind, so dass die Kaskoden als Dioden für das Wechselstromsignal wirken.

4. Spannungsgesteuerte Oszillatorschaltung nach einem der vorhergehenden Ansprüche, bei der ferner Widerstände (145, 155) vorgespannt werden, die so geschaltet sind, dass sie die Basisanschlüsse der zwei Kaskoden (140, 150) vorspannen.

5. Spannungsgesteuerte Oszillatorschaltung nach einem der vorhergehenden Ansprüche, die ferner einen Ausgangsverstärker umfasst, der zwei zusätzliche differenzielle Transistoren und zwei zusätzliche Kaskoden umfasst, die jeweils mit den zwei differenziellen Transistoren und den zwei Kaskoden gekoppelt sind, um einen differenziellen verstärkten Ausgang zu liefern.

6. Spannungsgesteuerte Oszillatorschaltung nach Anspruch 5, bei der die zwei zusätzlichen differenziellen Transistoren und die zwei zusätzlichen Kaskoden mit den zwei differenziellen Transistoren und den zwei Kaskoden jeweils über ihre Basisanschlüsse gekoppelt sind.

7. Spannungsgesteuerte Oszillatorschaltung nach Anspruch 5, bei der der differenzielle verstärkte Ausgang an Kollektoranschlüssen der zwei zusätzlichen Kaskoden bereitgestellt wird.

## Revendications

1. Circuit VCO comprenant:
un circuit résonnant oscillant (130),
une paire différentielle de transistors (110, 120) couplés de manière à commander le circuit oscillant (130),
une paire différentielle de cascodes (140, 150), branchée entre la paire différentielle (110, 120) et le circuit oscillant, la paire de cascodes (140, 150) comportant des bornes de base, et
un trajet de réaction différentiel couplé selon un couplage croisé à partir du circuit oscillant (130) pour commander la paire différentielle (110, 120),
les bornes de base de la paire de cascodes étant couplées selon un couplage croisé à courant alternatif par rapport à la paire différentielle (110, 120) de telle sorte que les courants alternatifs de base de la paire différentielle et de la paire de cascodes sont compensés d'une manière croisée.

2. Circuit VCO selon la revendication 1, dans lequel le trajet de réaction différentiel inclut des premiers condensateurs (162, 172) de blocage du courant continu.

3. Circuit VCO selon la revendication 1 ou la revendication 2, dans lequel les bornes de base de la paire différentielle de cascodes (140, 150) sont couplées selon un couplage croisé en courant alternatif à la paire différentielle au moyen de seconds condensateurs (165, 175) de blocage du courant continu, de sorte que les cascodes agissent en tant que diodes pour le signal à courant alternatif.

4. Circuit VCO selon l'une quelconque des revendications précédentes, comprenant en outre des résistances de polarisation (145, 155) couplées de manière à polariser les bornes de base de la paire de cascodes (140, 150).

5. Circuit VCO selon l'une quelconque des revendications précédentes, comprenant en outre un amplificateur de sortie comportant une paire différentielle supplémentaire et une paire de cascodes supplémentaire, dont chacune est couplée respectivement à la paire différentielle et à la paire de cascodes de manière à fournir un signal de sortie différentiel amplifié.

6. Circuit VCO selon la revendication 5, dans lequel la paire différentielle supplémentaire et la paire de cascodes supplémentaire sont couplées à la paire différentielle et à la paire de cascodes respectivement par l'intermédiaire de leurs bornes de base.

7. Circuit VCO selon la revendication 5, dans lequel le signal de sortie différentiel amplifié est prévu sur des bornes de collecteur de la paire de cascodes supplémentaire.
